# EUROPÄISCHE PATENTSCHRIFT

(11) **EP 2 439 774 B1**
(45) Veröffentlichungstag und Bekanntmachung des Hinweises auf die Patenterteilung: **02.01.2019**
(21) Anmeldenummer: 11181081.8
(22) Anmeldetag: 13.09.2011
(51) Int. Cl.: H01L 23/427, H01L 23/433

(54) **Wärmeverteiler mit flexibel gelagertem Wärmerohr**
Heat distributor with flexible heat tube
Dissipateur de chaleur doté d'un tuyau de chauffage stocké de manière flexible

(30) Priorität: 08.10.2010 DE 202010014106 U
(43) Veröffentlichungstag der Anmeldung: 11.04.2012
(73) Patentinhaber: Congatec AG, 94469 Deggendorf (DE)
(72) Erfinder: Pfaffinger, Konrad, 94469 Deggendorf (DE)
(74) Vertreter: Grünecker Patent- und Rechtsanwälte PartG mbB

(56) Entgegenhaltungen:
- US-A1- 2006 181 856
- US-A1- 2009 223 647
- US-A1- 2009 277 614
- US-A1- 2010 059 202
- US-A1- 2010 126 700
- US-A1- 2010 206 522

## Beschreibung

Die vorliegende Erfindung bezieht sich auf einen Wärmeverteiler zum Abführen von Wärme, die durch mindestens ein Wärme erzeugendes Leistungshalbleiterbauelement erzeugt wird. Insbesondere befasst sich die vorliegende Erfindung mit Wärmeverteilern, die neben einer verbesserten Wärmekopplung zwischen einem Chip und einem Kühlkörper auch eine flexible Kopplungsanordnung aufweist, die Toleranzen der Bauteile und des Montageprozesses ausgleichen kann.

Leistungshalbleiter werden beispielsweise auf Leiterplatten montiert, auf denen zusätzlich weitere Bauteile angebracht sind, die je nach Funktionalität der Leiterplatten variieren. Aufgrund der hohen Leistungsdichten, die heutzutage insbesondere im Zusammenhang mit Embedded-Computern auftreten, sind optimierte Kühllösungen erforderlich, um eine Zerstörung der Bauteile durch Überhitzung zu verhindern. Leiterplatten mit den Halbleiterbauelementen unterliegen dabei bestimmten Toleranzen, die bei der Montage der Kühlvorrichtung ausgeglichen werden sollten. Ein solcher Ausgleich von Toleranzen ist besonders bei Halbleiterbaugruppen wichtig, die in sogenannte Basisplatinen eingebaut werden. Solche Baugruppen werden üblicherweise "Computer on modules", COM-Lösungen genannt.

Die vorliegende Erfindung ist aber selbstverständlich für die Wärmeabfuhr bei beliebigen anderen elektronischen Komponenten, für die Kühlung von Halbleiterschaltern in Gleich- und Wechselrichtern, sogenannten Power-Modules, wie auch allen beliebigen anderen Einsatzgebieten, in denen überschüssige Wärme abgeführt werden soll, verwendbar.

COM-Lösungen sind hochintegrierte CPU-Module, die zwar keine selbstständig lauffähigen Computer darstellen, jedoch die wichtigsten Funktionselemente eines Computers enthalten. Erst durch den Einbau der Module in eine Basisplatine erhalten sie ihre Funktionalität, wie beispielsweise als Messgerät, Steuercomputer oder für eine andere Applikation. Die Systemerweiterung und -anpassung wird ausschließlich über die Basisplatine ermöglicht, wodurch eine teilweise kundenspezifische integrierte Lösung entsteht. Die Basisplatine enthält alle erforderlichen Anschlüsse, um das System an Peripheriegeräte wie Festplatten, Maus oder Bildschirm anzuschließen. Ein COM-Modul enthält beispielsweise den Prozessor, einen Prozessorbus sowie einen oder mehrere Speicher (RAM) und kann je nach Hersteller auch eine gewissen Anzahl von Standardperipheriefunktionen übernehmen. COM-Module können als Steckkarten in eine Basisplatine eingebaut werden oder flächig über entsprechende Verbinder mit der Basisplatine verbunden werden.

COM-Module haben üblicherweise ein spezifiziertes Interface zur Anbindung an geeignete Kühllösungen. Dieses Interface wird nachfolgend Wärmeverteiler (englisch: Heatspreader) genannt, wobei auch andere Bezeichnungen geläufig sind, wie Wärmespreizplatte, Hitzeverteiler oder auch Kühlkörper. Der Wärmeverteiler wird dazu verwendet, im COM-Modul eine Wärmeabfuhr von den aktiven Hitze erzeugenden Bauteilen wie CPU oder Chip zu ermöglichen und die Wärme an eine weitere Kühllösung, wie einen Kühlkörper oder eine Gehäusewandung, weiterzuleiten.

Eine große Stärke von COM-Modulen ist deren freie Austauschbarkeit. Die thermische Anbindung des Moduls an eine weitere Kühllösung erfolgt somit immer über die Wärmeverteileroberfläche an der gleichen geometrischen Position. Um eine Austauschbarkeit innerhalb der Systemumgebung ohne mechanische Anpassungen zu gewährleisten, sind COM-Module daher in ihren Abmessungen, wie Höhe, Breite und Länge genau spezifiziert.

Toleranzen der Bauteile und Soll-Abweichungen während des Montageprozesses, beispielsweise durch den Lötprozess, erschweren die positionsgenaue Anbindung der Basisplatine zum Wärmeverteiler. Bei ungünstigen Toleranzen entstehen unerwünschte mechanische Belastungen an dem Schaltungsträger, beispielsweise einer Leiterplatte, und dem Wärmeverteiler, was im schlimmsten Fall zu einer Durchbiegung der Leiterplatte führen kann.

Daher ist bekannt, den Wärmeverteiler zumindest teilweise mit einem flexiblen Wärmekopplungselement auszustatten, das flexibel mit Bezug auf eine Grundplatte des Wärmeverteilers angeordnet ist, um Toleranzen in den Abmessungen des Leistungshalbleiterbauelements aufzufangen.

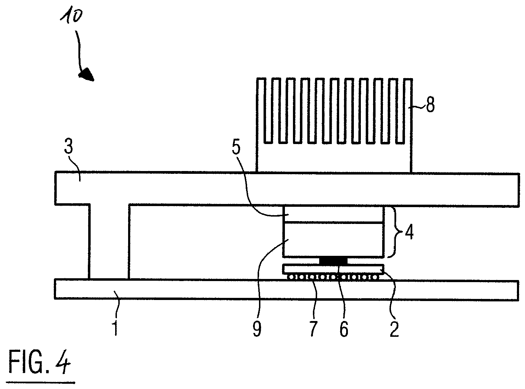

Fig. 4 zeigt in einer schematischen Schnittdarstellung eine Halbleitereinheit 10 mit einem Wärmeverteilter 3, wie sie beispielsweise aus der EP 1791177 A1 bekannt ist. Die Halbleitereinheit der Figur 4 wird üblicherweise in eine Basisplatine eingebaut, um eine anwendungsspezifische integrierte Lösung zu erzielen.

Ein Chip 2 mit einer aktiven und einer rückseitigen Fläche stellt hier den ausführenden Teil des CPU-Moduls dar, wobei die aktive Fläche des Chips 2 einen Prozessorkern 6 umfasst. Die rückseitige Fläche des Chips 2 ist auf einer Leiterplatte 1 montiert. Es können beispielsweise Lötkügelchen 7 verwendet werden, um den Chip elektrisch und fest mit der Leiterplatte zu verbinden. Der Chip 2 kann beispielsweise als oberflächenmontiertes (engl.= surface mounted device) Bauteil ausgeführt sein. Die "surface mount technology" SMT wird heute üblicherweise verwendet, da sie gegenüber früheren Verfahren zahlreiche Vorteile bietet. Das dabei verwendete Wiederaufschmelzlöten ist ein Weichlötverfahren, bei dem die Bauteile durch Weichlot und Lötpaste direkt auf einer Leiterplatte montiert werden. Allerdings sind darüber hinaus alle dem Fachmann geläufigen Techniken zur Montage eines Chips auf einer Leiterplatte möglich.

Während des Betriebs des COM-Moduls entsteht an dem Chip Hitze, die von dem Chip 2, inklusive Prozessorkern 6 abgeführt werden muss, um eventuelle Hitzeschäden an der Leiterplatte 1 und dem Chip 2 zu vermeiden. Ein Wärmeverteiler 3 ist über dem Chip 2 montiert und führt zum einen die Wärme vom Chip 2 ab und schützt zum anderen den Chip 2 vor möglichen Beschädigungen. Der Wärmeverteiler 3 ist mit der Leiterplatte lösbar verbunden.

Beispielsweise kann der Wärmeverteiler 3 durch entsprechende Befestigungsvorrichtungen mit Schrauben (nicht gezeigt) an die Leiterplatte montiert werden. Allerdings sind alle dem Fachmann geläufigen Montagemöglichkeiten, die eine lösbare Befestigung erlauben, ebenfalls denkbar. Darunter fallen beispielsweise auch Nieten-, Klammer- oder Klebebefestigungen (ebenfalls nicht gezeigt). Eine solche lösbare Montage hat den Vorteil, dass der Wärmeverteiler 3 ausgetauscht werden kann. Weiterhin kann für Reparaturarbeiten am Chip 2 der Wärmeverteiler 3 demontiert werden, wodurch der Chip 2 leichter erreichbar ist.

Um den Chip 2 thermisch an den Wärmeverteiler 3 anzubinden, wird eine thermisch leitfähige Wärmekopplungsanordnung 4 verwendet. Diese ist in Figur 4 zwischen der aktiven Fläche des Chips 2 und dem Wärmeverteiler 3 angeordnet, so dass eine direkte thermische Verbindung des wärmeerzeugenden Chips 2 mit dem Wärmeverteiler 3 hergestellt wird.

Die Halbleitereinheit wird als standardisierte Einheit in eine Basisplatine eingebaut und üblicherweise mit weiteren Kühllösungen des Systems verbunden. Eine solche Kühllösung ist in Figur 4 beispielhaft als eine Vielzahl von Kühlrippen 8 veranschaulicht. Andere Kühllösungen sind aber ebenfalls möglich. Dabei können alle dem Fachmann geläufigen Kühlkörper und Kühlprozesse Anwendung finden, wie beispielsweise eine Lüfter- oder Wasserkühlung. Weiters ist auch eine Wärmeabfuhr mittels zusätzlicher Heatpipes denkbar. Auch die Größe der Kontaktfläche zum Wärmeverteiler 3 ist je nach Systemumgebung geeignet zu wählen. Vorzugsweise liegt der Kühlkörper 8 an den vom Chip 2 abgewandten Seiten des Wärmeverteilers 3 an. Für die Funktion der vorliegenden Erfindung ist die verwendete Systemkühllösung 8 ohne große Bedeutung.

Eine standardisierte Anbindung an das System (Kühllösung, Basisplatine) erfordert genau spezifizierte Abmessungen der Halbleitereinheit. Bauteile werden zwar möglichst maßgenau gebaut, sind aber trotzdem gewissen Toleranzschwankungen unterworfen. Üblicherweise bewegen sich diese Toleranzen im Bereich von ± 0.2 mm. Darüber hinaus entstehen beispielsweise bei der Montage des Chips 2 auf der Leiterplatte 1 durch den Lötprozess Toleranzen. Diese Bau- und Montagetoleranzen erschweren zum einem die Anbindung an die Basisplatine, aber zum anderen auch die Montage der Halbleitereinheit.

Bei ungünstigen Toleranzkombinationen der Bauteile kann es zu mechanischen Belastungen kommen, die zu einer Durchbiegung der Leiterplatte 1 führen. Beispielsweise können große mechanische Belastungen bei großen positiven Toleranzen des Lötprozesses und/oder der Bauteile und bei einer nicht erfindungsgemäßen Wärmeanbindung an den Wärmeverteiler 3 auftreten. Bei der Anbindung an die Kühllösung 8 des Systems, hier beispielhaft eine Kühlrippe an derselben mechanischen Position, wird eine mechanische Kraft über den Wärmeverteiler 3 und die nicht erfindungsgemäße Wärmeanbindung auf den Chip 2 und damit auf die Leiterplatte 1 ausgeübt. Durch die mechanische Belastung wird die Leiterplatte 1 durchbogen, wobei dies durchaus zu Schäden führen kann.

Falls eine große negative Toleranz des Lötprozesses auftritt, so wird zwar keine mechanische Kraft auf die Leiterplatte ausgeübt, allerdings ist eine optimale Wärmeanbindung des Chips an die Systemkühllösung nicht gewährleistet. Es können Lücken zwischen der nicht erfindungsgemäßen Wärmeanbindung und dem Wärmeverteiler auftreten, welche die Wärmeabfuhr verschlechtern.

In einer Ausführungsform besteht die Wärmekopplungsanordnung 4 aus einem mehrschichtigen wärmeleitenden Block 4. Dabei umfasst die Wärmekopplungsanordnung erfindungsgemäß eine elastische Schicht 5. Diese elastische Schicht 5 ermöglicht einen Toleranzausgleich. Die mechanischen Belastungen die, wie oben erläutert, bei ungünstigen Toleranzen der Bauteile und des Lötprozesses auftreten können, werden von der elastischen Schicht 5 kompensiert. Die mechanische Kraft sorgt für eine Kompression der elastischen Schicht. Daher erfolgt keine Übertragung der Kraft auf die Leiterplatte 1 und somit auch keine Durchbiegung der Leiterplatte 1.

Da die elastische Schicht 5 komprimierbar ist, kann diese so ausgeführt sein, dass sie stets etwas dicker als nötig ist. Dadurch erfolgt immer eine lückenlose und damit uneingeschränkte Wärmeanbindung an den Wärmeverteiler 3, auch wenn, wie oben erläutert negative Toleranzen auftreten. In diesem Fall würde die elastische Schicht 5 weniger komprimiert werden als bei positiven Toleranzen des Lötprozesses und der Bauteile.

Die elastische Schicht 5 sollte eine möglichst große Fläche zum Wärmeverteiler 3 aufweisen und möglichst dünn sein, da die elastische Schicht 5 normalerweise eine schlechtere thermische Leitfähigkeit aufweist. Allerdings ist die Schicht bei abnehmender Dicke weniger elastisch und flexibel, wodurch eine größere Kraft nötig wäre, um Toleranzen auszugleichen. Deswegen muss ein Kompromiss zwischen thermischer Leitfähigkeit und Flexibilität gefunden werden.

Die elastische Schicht 5 kann dabei aus verschiedenen Materialien bestehen, solange diese gute Wärmeleiteigenschaften haben und ausreichend elastisch sind. Beispielhaft seien hier graphitgefüllte Silikone erwähnt. Jedoch können andere, dem Fachmann geläufige Materialien verwendet werden, die elastisch sind.

Zur besseren thermischen Anbindung der Wärmekopplungsanordnung 4 kann diese über eine dünne Schicht Wärmeleitpaste (nicht gezeigt), die einen geringen thermischen Übergangswiderstand besitzt, mit den Chip 2 verbunden werden.

Weiterhin ist bekannt, dass eine Schicht 9 des wärmeleitenden Blockes 4 aus Kupfer oder ähnlich gut wärmeleitenden Material besteht. Die Menge an thermischer Energie, welche die Kupferschicht aufnehmen kann, hängt von ihrem Volumen ab. Die Kupferschicht 9 liegt entweder direkt oder über eine dünne Schicht Wärmeleitpaste am Chip 2, beziehungsweise am Prozessorkern 6 an und nimmt dessen Hitze auf und gibt diese an weitere Schichten des wärmeleitenden Blockes 4 ab, in Figur 4 an die elastische Schicht 5. Diese wiederum gibt die Hitze an den Wärmeverteiler 3 weiter, der mit einer weiteren Kühltechnik 8 des Systems gekühlt wird.

Allerdings haben die Anordnungen, die in der EP 1791177 A1 beschrieben sind, den Nachteil, dass zum einen bei Wärmebelastung im Falle eines elastischen Materials die Gefahr besteht, dass sich Dämpfe des elastischen Kunststoffes 5, insbesondere bei Verwendung von Silikon, an unerwünschter Stelle abscheiden. Zum anderen hat die Ausführung mit federnden Teilen der Grundplatte den Nachteil, dass nicht genug Wärme von dem Halbleiterbauelement abgeführt werden kann, um besonders hohe Wärmespitzen aufzufangen. Darüber hinaus ist für moderne Halbleiter 2 die abführbare Wärmemenge pro Zeiteinheit oftmals nicht mehr ausreichend.

Insbesondere bezieht sich die US 2009/223647 A1 auf eine modulare Kühlkörperanordnung. Die Kühlkörperanordnung umfasst einen (größeren) Hauptkühlkörper, der eine oder mehrere durchgehende Aussparungen aufweist. Die Kühlkörperanordnung umfasst weiterhin einen oder mehrere zusätzliche (kleinere) Kühlkörper, die in die Aussparungen des Hauptkühlkörpers passen und in diesen Aussparungen beweglich sind, während sie thermisch mit dem Hauptkühlkörper verbunden sind. Die thermische Verbindung zu dem Hauptkühlkörper kann dadurch erreicht werden, dass Wärmerohre als Brücke zwischen den Kühlkörperelementen eingesetzt werden. Auf diese Weise erfolgen die Wärmeabfuhr und Wärmeregulierung über die zusätzlichen Kühlkörper und den Hauptkühlkörper.

Die US 2010/206522 A1 bezieht sich auf eine Kühlkörperanordnung, die einen ersten Kühlkörper aufweist, welcher thermisch mit einer elektronischen Komponente verbunden ist. Ein zweiter Kühlkörper ist mit dem ersten Kühlkörper verbunden und ein Wärmerohr verbindet den ersten mit dem zweiten Kühlkörper. Der erste Kühlkörper weist an einer Seite eine Ausnehmung auf. Das Wärmerohr hat einen Verdampfungsbereich, der mit dem ersten Kühlkörper verbunden ist, und einen Kondensationsbereich, der mit dem zweiten Kühlkörper verbunden ist, sowie einen Verbindungsbereich, der den Verdampfungsbereich und den Kondensationsbereich verbindet. Aus der Seite des zweiten Kühlkörpers ragt ein Eingriffsvorsprung heraus, der mit der Aufnahme des ersten Kühlkörpers fest verbunden ist und mit dieser zusammenwirkt. Das Wärmerohr erstreckt entlang des Eingriffsvorsprungs.

Aus der US 2010/059202 A1 ist eine Kühlkörperanordnung zum Kühlen eines elektrischen Bauelements bekannt, die eine leitfähige Platte und einem Wärmeverteiler aufweist, der in der leitfähigen Platte aufgenommen ist und das elektronische Bauelement kontaktiert. Ein Wärmerohr verbindet die leitfähige Platte und den Wärmeverteiler und ein elastisches Element, das auf der leitfähigen Platte montiert ist, presst den Kühlkörper und das Wärmerohr in dem Wärmeverteiler nach unten auf das elektronische Bauelement.

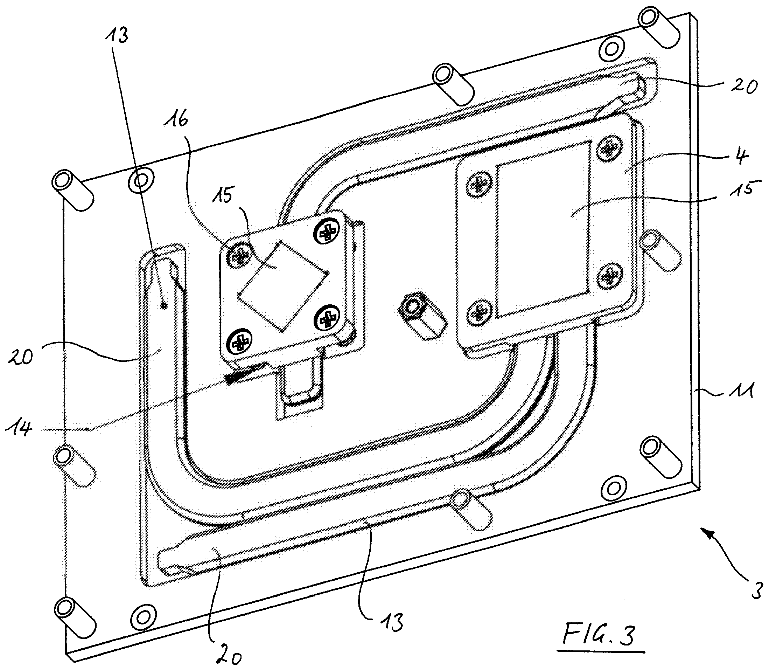

Die US 2009/277614 A1 offenbart eine wärmeleitfähige Struktur mit einer ersten und einer zweiten wärmeleitfähigen Platte und mindestens einem Wärmerohr. Wie beispielsweise aus den Figuren 3 bis 5 hervorgeht, sind die Wärmerohre zwischen den beiden Platten eingeklemmt. Die Grundplatte besitzt einen U-förmigen Querschnitt, so dass zwei Seitenbereiche der wärmeleitfähigen Struktur geschlossen sind, während zwei weitere Seitenbereiche offen sind und beispielsweise von Luft durchströmt werden können.

Die US 2010/126700 A1 bezieht sich auf eine Wärme abstrahlende Grundplatte, die eine aus Aluminium hergestellte obere Grundplatte und eine aus Kupfer hergestellte untere Grundplatte sowie ein Wärmerohr aufweist. Die obere Grundplatte weist schlitzförmige Strukturen auf, in welche das Wärmerohr eingelegt wird.

Die US 2006/0181856 A1 offenbart eine Kühlkörpervorrichtung für ein Video-Grafik-Array (VGA) und einen Chipsatz. Das Hauptmerkmal ist ein integriertes Design für den Kühlkörper. Eine gemeinsame Kühlkörperplatte wird auf das VGA und den Chipsatz (anstelle von mehreren) angepresst. Die Kühlkörperplatte hat eine größere Wärmeableitungsfläche als die eines herkömmlichen Kühlkörpers. Die Vorrichtung integriert auch andere wärmeerzeugende Elemente, die unterhalb der Kühlkörperplatte angeordnet sind, um mehr Wärme abzuführen, um so den Wärmeableitungseffekt der Kühlkörperplatte zu erhöhen. Wärmerohre sind durch Öffnungen in einem Gleitblock hindurchgeführt und an einer dem Chipsatz zugewandten Oberfläche der Kühlkörperplatte angelegt.

Die Aufgabe, die der vorliegenden Erfindung zugrunde liegt, besteht darin, eine verbesserte Wärmeableitung von einem wärmeerzeugenden Leistungshalbleiterbauelement, wie einer CPU oder einem Chipsatz, zum Wärmeverteiler zu ermöglichen, wobei der Wärmeverteiler kostengünstig herstellbar sein soll. Weiterhin soll eine möglichst positionsgenaue Anbindung des COM-Moduls an die Systemkühllösung bei möglichst geringen mechanischen Belastungen gewährleistet werden.

Diese Aufgabe wird gemäß der vorliegenden Erfindung durch einen Wärmeverteiler mit den Merkmalen des Anspruchs 1 gelöst.

Gemäß der vorliegenden Erfindung umfasst ein Wärmeverteiler eine Grundplatte, die mit mindestens einem Leistungshalbleiterbauelement wärmeleitend verbindbar ist. Die Grundplatte weist eine Ausnehmung auf, in welcher mindestens ein Wärmerohr zum Abführen der erzeugten Wärme angeordnet ist. Erfindungsgemäß ist dieses mindestens eine Wärmerohr in der Ausnehmung der Grundplatte beweglich gelagert.

Wärmerohre (englisch: Heatpipes) sind allgemein bekannt und beispielsweise in der EP 0191419 B1 gezeigt. Es handelt sich bei einem solchen Wärmerohr um einen geschlossenen Raum, der teilweise mit einer Flüssigkeit gefüllt ist. Das Wandmaterial und die Art der Flüssigkeit hängen im Wesentlichen von dem Temperaturbereich ab, in welchem das Wärmerohr arbeiten soll. Bei Wärmezufuhr an einer Stelle des Wärmerohrs (der Heizzone) verdampft die Flüssigkeit und der Dampf verteilt sich über den gesamten Innenraum. An einer Wärmesenke (der Kondensationszone) kondensiert der Dampf und gibt dabei Wärme ab. Die Arbeitsflüssigkeit muss zur Heizzone zurück transportiert werden. Dies kann mit Hilfe der Schwerkraft geschehen, wenn man das Wärmerohr so anordnet, dass die Heizzone unten und die Wärmesenke weiter oben ist. Der Rücktransport der Flüssigkeit kann jedoch auch durch Kapillarkräfte erfolgen, wozu die Innenwand mit Rillen, Netzen oder einer porösen Schicht versehen wird. Das Wärmerohr zeichnet sich dadurch aus, dass die Wärme von einer Wärmequelle, also dem Wärme erzeugenden Halbleiterbauelement hin zu einer weiter entfernten und/oder größerflächigen Wärmesenke bei nur geringen Temperaturabfall transportiert werden kann. Die von dem Wärmerohr gebildete Kammer muss nicht zylindrisch sein; ein Wärmerohr kann einen nahezu beliebigen Querschnitt aufweisen.

Durch die erfindungsgemäße bewegliche Lagerung des Wärmerohrs mit Bezug auf die Grundplatte kann erreicht werden, dass trotz vorhandener Fertigungstoleranzen bei der Aufbauhöhe der Leistungshalbleiterbauelemente ein optimaler Wärmeübergang zu dem Wärmerohr erreicht wird. Das Vorsehen eines Wärmerohrs ermöglicht eine wesentlich verbesserte Abfuhr der Wärme in Bereiche, in denen im Einbau beispielsweise Kühlkörper angeordnet werden können.

Durch Vorsehen eines zusätzlichen Wärmekopplungselements, das mit dem Leistungshalbleiterbauelement einerseits und mit dem Wärmerohr andererseits wärmeleitend verbunden ist, lässt sich eine Vermittlung der unterschiedlichen Flächen des Halbleiterbauelements und des Wärmerohrs realisieren. Gleichzeitig kann das Wärmekopplungselement auch als Puffer dienen, um Temperaturspitzen abzufangen.

Einen optimalen Wärmeübergang einerseits und eine minimale mechanische Belastung der Chips andererseits zu erreichen, wird gemäß einer vorteilhaften Ausführungsform der vorliegenden Erfindung der Anpressdruck des Wärmekopplungselements auf das Wärmerohr und/oder auf das Leistungsbauelement über mindestens ein Federelement definiert eingestellt. Dabei kann das Federelement gemäß einer vorteilhaften Ausführungsform z.B. eine Spiralfeder mit definierter Federkonstante umfassen. Die Spiralfeder lagert das Wärmekopplungselement federnd mit Bezug auf die Grundplatte. Alternativ können aber auch Federringe oder Federbleche eingesetzt werden.

In vorteilhafter Weise kann dieses Wärmekopplungselement aus Kupfer hergestellt sein. Dieser Werkstoff hat den Vorteil, dass er eine besonders gute Wärmeleitfähigkeit besitzt. Andere metallische oder sonstigen gut wärmeleitenden Materialien sind natürlich ebenfalls verwendbar.

Gemäß einer vorteilhaften Ausführungsform der vorliegenden Erfindung weist das Wärmerohr einen abgeflachten Querschnitt auf, der so bemessen ist, dass das Wärmerohr eine Dicke kleiner oder gleich der Dicke der Grundplatte aufweist. Darüber hinaus sind derartige abgeflachte Wärmerohre leicht in der gewünschten Richtung auslenkbar, um den Toleranzausgleich zwischen Grundplatte und Chip herstellen zu können.

Dadurch, dass die Ausnehmung wenigstens teilweise durch eine durch die Grundplatte hindurchgehende Öffnung gebildet ist, kann auf einfache Weise sichergestellt werden, dass zum Auslenken eines Wärmerohrs genügend Raum vorhanden ist.

Damit andererseits der Kondensationsbereich des Wärmerohrs möglichst gut wärmeleitend mit der Grundplatte gekoppelt ist, ist die Ausnehmung in diesen Bereichen durch eine Nut in der Grundplatte gebildet, so dass das Wärmerohr mit mindestens einer Wandung der Grundplatte in wärmeleitender Verbindung steht.

Auf besonders einfache und kostengünstige Art und Weise kann die Ausnehmung in der Grundplatte durch Fräsen, während des Herstellungsprozesses der Platte durch Druckguss oder durch Erosion hergestellt werden.

Ein kostengünstiges und gleichzeitig gut wärmeleitendes Material für die Grundplatte ist Aluminium. Selbstverständlich können aber auch andere Wärme leitende Materialien eingesetzt werden. Weiterhin wird das mindestens eine Wärmerohr in vorteilhafter Weise aus Kupfer gefertigt, wobei selbstverständlich auch alle anderen üblichen Materialien verwendbar sind.

Um die Lötbarkeit der einzelnen Komponenten zu ermöglichen, sind gemäß einer vorteilhaften Ausführungsform die Grundplatte, das Wärmerohr und/oder das Wärmekopplungselement mit einer Nickelschicht überzogen.

Um eine nochmals verbesserte Wärmekopplung zwischen dem Leistungshalbleiterbauelement und dem Wärmeverteiler zu gewährleisten, kann noch eine zusätzliche Wärme leitende Zwischenschicht vorgesehen sein.

Diese Zwischenschicht kann weiterhin ein Latentwärmespeichermaterial umfassen. Unter Latentwärmespeicherung versteht man allgemein die Speicherung von Wärme in einem Material, welches einen Phasenübergang, vorwiegend fest/flüssig, erfährt (englisch: phase change material, PCM).

Neben dem Phasenübergang fest/flüssig können prinzipiell auch fest/fest Phasenübergänge eingesetzt werden. Diese zeigen in der Regel jedoch weit geringere Wärmespeicherdichten. Bei der Einspeicherung von Wärme in das Speichermaterial beginnt das Material bei Erreichen der Temperatur des Phasenübergangs zu schmelzen und erhöht dann trotz weiterer Einspeicherung von Wärme seine Temperatur nicht mehr, bis das Material komplett geschmolzen ist. Erst dann tritt wieder eine Erhöhung der Temperatur auf. Da für längere Zeit keine Temperaturerhöhung auftritt, bezeichnet man die während des Phasenübergang eingespeicherte Wärme als versteckte Wärme oder latente Wärme. Dieser Effekt ermöglicht es, Temperaturschwankungen zu glätten und Temperaturspitzen, die den Halbleiter schädigen könnten, zu verhindern. Das Latentwärmespeichermaterial wird je nach Temperaturbereich gewählt. Meist kommen verschiedene Salze und deren eutektische Mischungen zum Einsatz.

In vorteilhafter Weise wird die Grundplatte so ausgeführt, dass sie mit einem zusätzlichen Kühlkörper oder einem Gehäuse verbindbar ist.

Zum besseren Verständnis der vorliegenden Erfindung wird diese anhand der in den nachfolgenden Figuren dargestellten Ausführungsbeispielen näher erläutert. Dabei werden gleiche Teile mit gleichen Bezugszeichen und gleichen Bauteilbezeichnungen versehen. Weiterhin können auch einige Merkmale und Merkmalskombinationen aus den gezeigten und beschriebenen Ausführungsformen für sich eigenständige erfinderische oder erfindungsgemäße Lösungen darstellen. Es zeigen:
- **Fig. 1**: eine perspektivische Darstellung eines Wärmeverteilers gemäß einer vorteilhaften Ausführungsform;
- **Fig. 2**: eine gekippte Ansicht des Wärmeverteilers der Fig. 2;
- **Fig. 3**: eine perspektivische Darstellung eines Wärmeverteilers gemäß einer weiteren vorteilhaften Ausführungsform;
- **Fig. 4**: eine schematische Schnittdarstellung einer Halbleitereinheit.

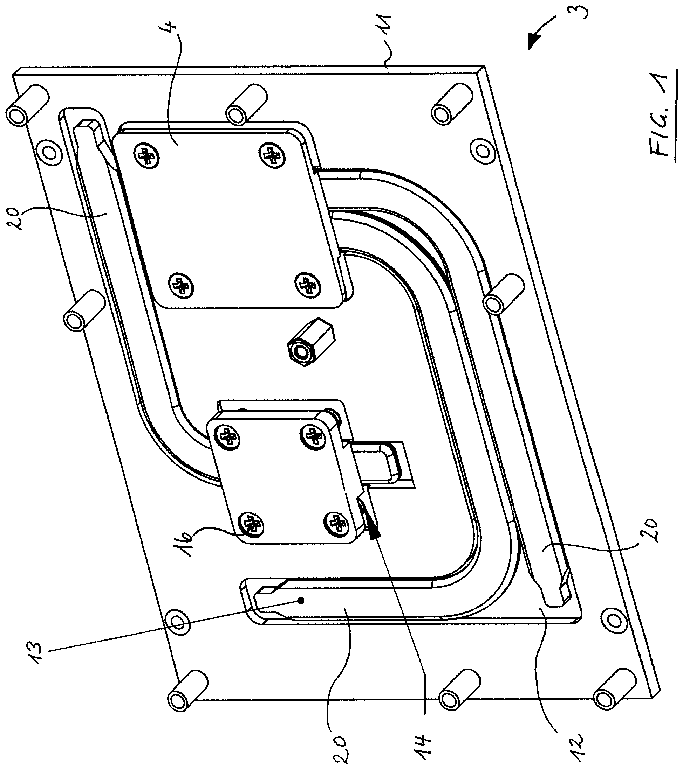

Fig. 1 zeigt in einer perspektivischen Darstellung die erfindungsgemäße Wärmeverteileranordnung 3, die in der Halbleitereinheit 10 aus Fig. 3 vorteilhaft zum Kühlen der Leistungshalbleiterbauelemente 2 eingesetzt werden kann. Der Wärmeverteiler 3 umfasst dabei eine Grundplatte 11, die beispielsweise aus Aluminium hergestellt sein kann. Damit an der Oberfläche der Grundplatte 11 keine störende Oxidschicht vorhanden ist, die ein Verlöten z.B. mit weiteren Schaltungskomponenten oder einem Kühlkörper verhindern würde, ist die Oberfläche der Grundplatte 11 beispielsweise vernickelt. Für einen Fachmann ist aber klar, dass die Wärmeverteilergrundplatte 11 aus allen weiteren für einen Fachmann üblichen Materialien, wie beispielsweise auch einer hochwärmeleitfähigen Keramik hergestellt sein kann.

In der Grundplatte 11 sind gemäß der vorliegenden Erfindung Ausnehmungen 12 angebracht, in denen Wärmerohre 13 aufgenommen sind. Die Ausnehmungen 12 sind dabei beispielsweise durch einen Fräsvorgang in der Grundplatte hergestellt.

Die Wärmerohre 13, in dem gezeigten Fall zwei für die Abfuhr der Wärme eines CPU-Chips und eines für die Abfuhr der von einem Interfacecontrollerhub erzeugten Wärme, bestehen z. B. aus vernickeltem Kupfer und besitzen einen abgeflachten Querschnitt, so dass sie fast vollständig innerhalb der Dicke der Grundplatte 11 aufgenommen sind.

Allerdings ist für einen Fachmann klar, dass auch alle anderen geeigneten Materialien und geeigneten geometrischen Ausgestaltungen gemäß den Prinzipien der vorliegenden Erfindung Verwendung finden können.

Gemäß dem oben erläuterten Funktionsprinzip besitzen die Wärmerohre 13 eine Heizzone 18 und eine Kondensationszone 20.

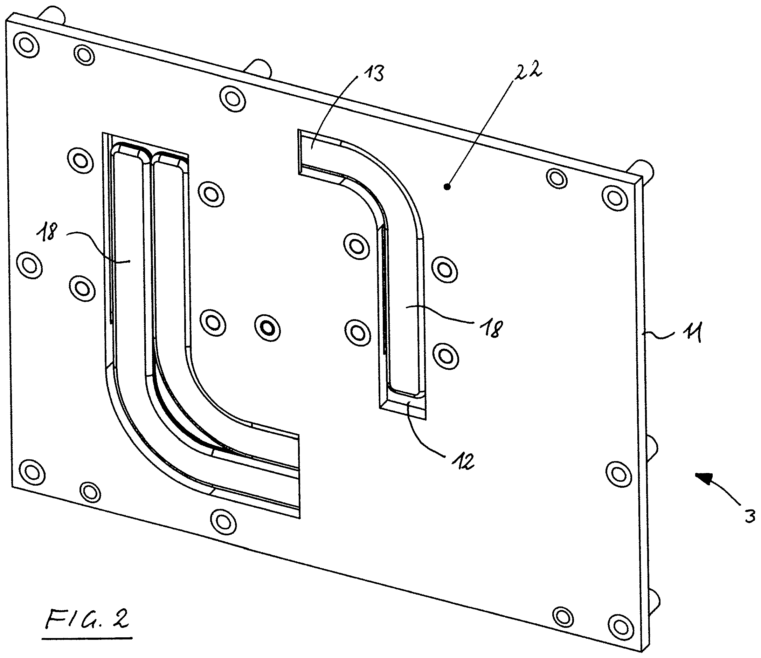

Wie in der Zusammenschau mit Fig. 2 erkennbar ist, sind die Ausnehmungen 12 im Bereich der Heizzonen, in welchen der mechanische Kontakt zu dem Chip hergestellt wird, als durchgehende Öffnungen ausgestaltet, so dass genügend Raum bleibt, um die Wärmerohre 13 auszulenken, falls dies für einen Toleranzausgleich erforderlich sein sollte. Im Bereich der Kondensationszonen 20 ist die Ausnehmung 12 dagegen als Nut in der Grundplatte 11 ausgeführt, so dass die Kondensationszonen 20 der Wärmerohre 13 hier in besonders großflächiger Anlage mit der Grundplatte 11 sind. Dadurch kann eine besonders effektive Kühlung erreicht werden.

Um weiterhin den thermischen Kontakt zu den (in den Fig. 1 und 2 nicht dargestellten) Chips zu erhöhen, ist der Wärmeverteiler 3 gemäß der vorliegenden Erfindung mit Wärmekopplungselementen 4 ausgestattet.

Gemäß einer vorteilhaften Ausführungsform werden die Wärmekopplungselemente aus Kupfer hergestellt und mit einer Nickelschicht überzogen. Weitere Materialien, z. B. Aluminium oder Magnesium sowie Mehrschichtaufbauten, sind natürlich ebenfalls einsetzbar.

Gemäß einer vorteilhaften Ausführungsform der vorliegenden Erfindung werden diese Wärmekopplungselemente 4 nicht starr mit dem auslenkbaren Wärmerohr 13 verbunden, sondern über eine gefederte Lagerung mittels Spiralfedern 14 an der Grundplatte 11 fixiert. Gesenkschrauben 16 und Abstandshalter, die im Inneren der Spiralfedern 14 angeordnet sind, sichern die Wärmekopplungselemente 4 an der Grundplatte 11.

In der gezeigten Ausführungsform sind die Wärmerohre außerdem innerhalb der Grundplattenebene gebogen angeordnet, um Raum zu sparen.

Fig. 2 zeigt die den Leistungshalbleiterbauelementen 2 abgewandte Oberfläche 22 des Wärmeverteilers 3. Diese Oberfläche 22 ist in der gezeigten Ausführungsform so ausgestaltet, dass ein Kühlkörper oder auch ein Gehäuse in direkter Wärme ableitendem Kontakt mit dem Wärmeverteiler 3 gebracht werden kann. Alternativ kann aber auf der Oberfläche 22 auch eine strukturierte Geometrie, beispielsweise eine Kühlrippenoberfläche zur besseren Luftkühlung angebracht sein. Die jeweilige Ausgestaltung liegt im Belieben des Fachmanns und hängt von der gewünschten Applikationsumgebung ab.

Gemäß einer weiteren vorteilhaften Ausführungsform, die in den Fig. 3 dargestellt ist, kann zusätzlich auf dem Wärmekopplungselement 4 noch eine weitere Zwischenschicht, z. B. Latentwärmespeicherelement 15, angebracht sein, um als zusätzlicher Wärmepuffer zum Abdämpfen von Temperaturspitzen dienen zu können. Dieses Latentwärmespeicherelement 15 kann mechanisch beispielsweise mittels eines Bolzens auf dem Wärmekopplungselement 4 gesichert werden. Derartige Latentwärmespeichermaterialien, wie sie im Zusammenhang mit der vorliegenden Erfindung verwendet werden können, sind in der US-Patentschrift 6,197,859 B1 beschrieben.

Mit Hilfe der erfindungsgemäßen Computerprozessor-Heatpipe-Kühlung mit definierter Federkonstante, wie sie gemäß der gezeigten Erfindung realisiert ist, kann ein optimaler Anpressdruck zwischen Wärmeverteiler 3 und Leistungshalbleiterbauelement 2 erzielt werden. Im Vergleich zu einer Standard-Heatspreader-Platte wird bei dieser Lösung die abgeflachte Heatpipe zur Übertragung der Wärme vom Chip zur Heatspreader-Platte verwendet. Dadurch erhöht sich in vorteilhafter Weise der Wärmetransport aus der Prozessorumgebung des Heatspreaders und verteilt sie auf der gesamte Heatspreader-Oberfläche. Des Weiteren sorgen die Spiralfedern 14 mit einer definierten Federkonstante für den optimalen Anpressdruck der Kühllösung auf den Prozessorchip. Die Heatpipe unterstützt in ihrer flexiblen Höhe den optimalen Anpressdruck. Bei bekannten Lösungen besteht das Problem, dass durch die unterschiedliche Prozessorhöhe - bedingt durch den Lötprozess - das Problem, dass kein genauer Anpressdruck einer starren Kühllösung auf den Prozessorchip möglich ist, und dass der Prozessor somit nicht optimal gekühlt werden kann.

## Patentansprüche

1. Wärmeverteiler zum Abführen von Wärme, die durch mindestens ein wärmeerzeugendes Leistungshalbleiterbauelement (2) erzeugt wird, wobei der Wärmeverteiler (3) umfasst:
eine Grundplatte (11), die mit dem mindestens einen Leistungshalbleiterbauelement (2) wärmeleitend verbindbar ist;
wobei die Grundplatte (11) mindestens eine Ausnehmung (12) aufweist, in der mindestens ein Wärmerohr (13) mit einer Heizzone (18) zum Zuführen von Wärme und einer Kondensationszone (20) zum Abführen der erzeugten Wärme angeordnet ist, und wobei das mindestens eine Wärmerohr (13) in der Ausnehmung (12) beweglich gelagert ist,
mindestens ein Wärmekopplungselement (4), das mit dem mindestens einen Leistungshalbleiterbauelement (2) einerseits wärmeleitend verbindbar ist und dem Wärmerohr (13) andererseits wärmeleitend verbunden ist,
wobei die Ausnehmung (12) im Bereich der Heizzone (18) als eine durch die Grundplatte hindurchgehende Öffnung ausgestaltet ist, so dass ein mechanischer Kontakt zwischen der Heizzone (18) und dem Leistungshalbleiterbauelement (2) durch das Wärmekopplungselement (4) hindurch herstellbar ist,
**dadurch gekennzeichnet,**
**dass** das mindestens eine Wärmekopplungselement (4) auf einer dem Leistungshalbleiterbauelement (2) gegenüberliegenden Fläche mit dem Wärmerohr (13) verbunden ist und über eine gefederte Lagerung an einer dem Leistungshalbleiterbauelement (2) zugewandten Fläche der Grundplatte (11) fixiert ist, und dass die Ausnehmung (12) wenigstens teilweise durch eine Nut in der Grundplatte (11) gebildet ist, so dass die Kondensationszone (20) des Wärmerohrs (13) mit einer Wandung der Grundplatte in wärmeleitender Verbindung steht.

2. Wärmeverteiler nach Anspruch 1, wobei die gefederte Lagerung mindestens ein Federelement (14) umfasst und ein Anpressdruck des Wärmekopplungselements (4) auf das Wärmerohr (13) und/oder auf das Leistungshalbleiterbauelement (2) über das mindestens eine Federelement (14) einstellbar ist.

3. Wärmeverteiler nach Anspruch 2, wobei das Federelement (14) eine Spiralfeder mit definierter Federkonstante umfasst, die das Wärmekopplungselement (4) federnd mit Bezug auf die Grundplatte (11) lagert.

4. Wärmeverteiler nach einem der Ansprüche 2 bis 3, wobei das Wärmekopplungselement (4) aus Kupfer, Aluminium oder Magnesium gefertigt ist.

5. Wärmeverteiler nach einem der vorangehenden Ansprüche, wobei das Wärmerohr (13) einen abgeflachten Querschnitt aufweist.

6. Wärmeverteiler nach Anspruch 5, wobei Querschnitt des Wärmerohrs (13) so bemessen ist, dass das Wärmerohr (13) eine Dicke kleiner oder gleich einer Dicke der Grundplatte aufweist.

7. Wärmeverteiler nach einem der vorangehenden Ansprüche, wobei die Grundplatte (11) aus Aluminium, gefertigt ist und/oder das mindestens eine Wärmerohr (13) aus Kupfer, gefertigt ist.

8. Wärmeverteiler nach einem der vorangehenden Ansprüche, wobei die Grundplatte (11), das Wärmerohr (13) und/oder das Wärmekopplungselement (4) mit einer Oberflächenbeschichtung versehen sind.

9. Wärmeverteiler nach Anspruch 8, wobei die Grundplatte (11), das Wärmerohr (13) und/oder das Wärmekopplungselement (4) mit einer Oberflächenbeschichtung aus Nickel versehen sind.

10. Wärmeverteiler nach einem der vorangehenden Ansprüche, wobei zum Ankoppeln des mindestens einen Leistungshalbleiterbauelements (2) an den Wärmeverteiler (3) eine wärmeleitende Zwischenschicht vorgesehen ist.

11. Wärmeverteiler nach Anspruch 10, wobei die Zwischenschicht ein Latentwärmespeichermaterial (15) umfasst.

12. Wärmeverteiler nach Anspruch 10 oder 11, wobei die Zwischenschicht mechanisch an dem Wärmekopplungselement (4) gesichert ist.

13. Wärmeverteiler nach einem der vorangehenden Ansprüche, wobei die Grundplatte (11) mit einem Kühlkörper (8) verbindbar ist oder eine wärmeabgebende Oberflächenstruktur aufweist.

14. Verfahren zum Herstellen eines Wärmeverteilers nach einem der vorangehenden Ansprüche, wobei die Ausnehmung (12) durch Fräsen, Druckguss oder Erodieren hergestellt wird.

## Claims

1. A heat spreader for dissipating heat generated by at least one heat-generating power semiconductor device (2), the heat spreader (3) comprising
a base plate (11) which is connectable in a heat-conducting manner to the at least one power semiconductor device (2),
wherein the base plate (11) has at least one recess (12) in which at least one heat pipe (13) is arranged, the heat pipe having a heating zone (18) for receiving heat and a condensation zone (20) for dissipating the generated heat, and wherein the at least one heat pipe (13) is movably supported in the recess (12),
at least one heat coupling element (4) which is connected in a heat-conducting manner to the at least one power semiconductor device (2) on the one hand and to the heat pipe (13) on the other hand,
wherein the recess (12) is formed in the region of the heating zone by an opening extending through the base plate (11), so that a mechanical contact may be established between the heating zone (18) and the power semiconductor device (2) through the heat coupling element (4),
**characterized in**
**that** the at least one heat coupling element (4) is connected to the heat pipe (13) on a surface opposing to the power semiconductor device (2), and is attached to a surface of the base plate (11) adjacent to the power semiconductor device (2) via a resilient bearing, and wherein the recess (12) is formed at least in part by a groove in the base plate (11), so that the heat pipe (13) is in heat-conducting communication with a wall of the base plate.

2. The heat spreader according to claim 1, wherein the resilient bearing comprises at least one spring element (14) and wherein a contact pressure of the heat coupling element (4) on the heat pipe (13) and/or on the power semiconductor device (2) is adjustable via the at least one spring element (14).

3. The heat spreader according to claim 2, wherein the spring element (14) includes a spiral spring having a defined spring constant, which resiliently supports the heat coupling element (4) relative to the base plate (11).

4. The heat spreader according to any one of claims 2 to 3, wherein the heat coupling element (4) is made from copper, aluminum or magnesium.

5. The heat spreader according to any one of the preceding claims, wherein the heat pipe (13) has a flattened cross-section.

6. The heat spreader according to claim 5, wherein the cross section of the heat pipe (13) is dimensioned such that the heat pipe (13) has a thickness smaller than or equal to a thickness of the base plate.

7. The heat spreader according to any one of the preceding claims, wherein the base plate (11) is made of aluminum and/or wherein the at least one heat pipe (13) is made of copper.

8. The heat spreader according to any one of the preceding claims, wherein the base plate (11), the heat pipe (13) and/or the heat coupling element (4) is/are provided with a surface coating.

9. The heat spreader according to claim 8, wherein the base plate (11), the heat pipe (13) and/or the heat coupling element (4) is/are provided with a surface coating of nickel.

10. The heat spreader according to any one of the preceding claims, wherein a heat-conducting interlayer is provided for coupling the at least one power semiconductor device (2) to the heat spreader (3).

11. The heat spreader according to claim 14, wherein the interlayer comprises a latent-heat storage material (15).

12. The heat spreader according to claim 14 or 15, wherein the interlayer is mechanically secured on the heat coupling element (4).

13. The heat spreader according to any one of the preceding claims, wherein the base plate (11) is connectable to a heat sink (8) or a heat-releasing surface structure, preferably cooling fins.

14. Method of fabricating a heat spreader according to any one of the preceding claims, wherein the recess (12) is formed by milling, die casting or eroding.

## Revendications

1. Dissipateur de chaleur pour évacuer de la chaleur qui est produite par au moins un composant à semiconducteur de puissance (2) produisant de la chaleur, le dissipateur de chaleur (3) comprenant :
une plaque de base (11), qui peut être reliée au dit au moins un composant à semiconducteur de puissance (2) par une liaison conduisant la chaleur ;
la plaque de base (11) présentant au moins un évidement (12) dans lequel est agencé au moins un tube calorifique (13) avec une zone chaude (18) pour l'amenée de chaleur, et une zone de condensation (20) destinée à l'évacuation de la chaleur produite, et ledit au moins un tube calorifique (13) étant monté de manière mobile dans l'évidement (12),
au moins un élément de couplage calorifique (4), qui peut être relié par une liaison conduisant la chaleur, au dit au moins un composant à semiconducteur de puissance (2) d'une part, et qui est relié d'autre part, par une liaison conduisant la chaleur, au tube calorifique (13),
l'évidement (12) étant réalisé, dans la région de la zone chaude (18), sous la forme d'une ouverture traversant la plaque de base, de manière à pouvoir établir un contact mécanique entre la zone chaude (18) et le composant à semiconducteur de puissance (2), par l'intermédiaire de l'élément de couplage calorifique (4),
**caractérisé**
**en ce que** ledit au moins un élément de couplage calorifique (4) est relié, sur une surface opposée à celle où se trouve le composant à semiconducteur de puissance (2), au tube calorifique (13), et est fixé par un montage élastique sur une surface de la plaque de base (11), qui est dirigée vers le composant à semiconducteur de puissance (2), et en ce que l'évidement (12) est formé au moins en partie par une rainure dans la plaque de base (11), de sorte que la zone de condensation (20) du tube calorifique (13) est en contact de transmission de chaleur avec une paroi de la plaque de base.

2. Dissipateur de chaleur selon la revendication 1, dans lequel le montage élastique comprend au moins un élément de ressort (14), et une pression d'application de l'élément de couplage calorifique (4) sur le tube calorifique (13) et/ou sur le composant à semiconducteur de puissance (2), peut être réglée par l'intermédiaire dudit au moins un élément de ressort (14).

3. Dissipateur de chaleur selon la revendication 2, dans lequel l'élément de ressort (14) comprend un ressort hélicoïdal avec une constante de ressort définie, qui assure un montage élastique de l'élément de couplage calorifique (4) par rapport à la plaque de base (11) .

4. Dissipateur de chaleur selon l'une des revendications 2 à 3, dans lequel l'élément de couplage calorifique (4) est fabriqué en cuivre, en aluminium ou en magnésium.

5. Dissipateur de chaleur selon l'une des revendications précédentes, dans lequel le tube calorifique (13) présente une section transversale aplatie.

6. Dissipateur de chaleur selon la revendication 5, dans lequel la section transversale du tube calorifique (13) est dimensionnée de manière telle, que le tube calorifique (13) présente une épaisseur inférieure ou égale à une épaisseur de la plaque de base.

7. Dissipateur de chaleur selon l'une des revendications précédentes, dans lequel la plaque de base (11) est fabriquée en aluminium, et/ou ledit au moins un tube calorifique (13) est fabriqué en cuivre.

8. Dissipateur de chaleur selon l'une des revendications précédentes, dans lequel la plaque de base (11), le tube calorifique (13) et/ou l'élément de couplage calorifique (4) sont pourvus d'un revêtement de surface.

9. Dissipateur de chaleur selon la revendication 8, dans lequel la plaque de base (11), le tube calorifique (13) et/ou l'élément de couplage calorifique (4) sont pourvus d'un revêtement de surface en nickel.

10. Dissipateur de chaleur selon l'une des revendications précédentes, dans lequel pour le couplage dudit au moins un composant à semiconducteur de puissance (2) au dissipateur de chaleur (3), il est prévu une couche intermédiaire conduisant la chaleur.

11. Dissipateur de chaleur selon la revendication 10, dans lequel la couche intermédiaire comprend un matériau d'accumulation de chaleur latente (15).

12. Dissipateur de chaleur selon la revendication 10 ou la revendication 11, dans lequel la couche intermédiaire est sécurisée mécaniquement à l'élément de couplage calorifique (4).

13. Dissipateur de chaleur selon l'une des revendications précédentes, dans lequel la plaque de base (11) peut être reliée à un corps de refroidissement (8) ou bien présente une structure de surface dissipant la chaleur.

14. Procédé pour la fabrication d'un dissipateur de chaleur selon l'une des revendications précédentes, d'après lequel l'évidement (12) est obtenu par fraisage, par moulage sous pression ou par érosion.
